Europäisches Patentamt

(19) European Patent Office

Office européen des brevets

(11) Publication number: **0 060 026**
**B1**

(12) **EUROPEAN PATENT SPECIFICATION**

(45) Date of publication of patent specification: **03.07.85**

(21) Application number: **82300616.8**

(22) Date of filing: **08.02.82**

(51) Int. Cl.⁴: **H 03 F 1/30**

(54) Gain stage with operational amplifier and switched capacitor resistor equivalent circuit.

(30) Priority: **03.03.81 US 239945**

(43) Date of publication of application:
**15.09.82 Bulletin 82/37**

(45) Publication of the grant of the patent:
**03.07.85 Bulletin 85/27**

(84) Designated Contracting States:
**DE FR GB NL**

(56) References cited:
**DE-A-2 834 920**
**GB-A-2 068 189**
**US-A-4 297 642**
**WESCON CONFERENCE RECORD, volume 24,**
**september 16-18, 1980 ANAHEIM CA (US) D.**
**BINGHAM: "Analog Circuit Performance**
**improves with MOS/CMOS techniques",**
**pages 26/1, 1-14**
**NACHRICHTENTECHNIK - ELEKTRONIK,**
**volume 23, no. 8, 1973 VEB Technik, BERLIN**
**(DD) M. SEIFART: "Spannungsspitzen bei**
**Messzerhackern mit Feldeffekt-transistoren",**
**pages 306-309**

(73) Proprietor: **AMERICAN MICROSYSTEMS,**
**INCORPORATED**
**3800 Homestead Road**
**Santa Clara, CA 95051 (US)**

(72) Inventor: **Amir, Gideon**
**2562 Hill Park Drive**
**San Jose California 95124 (US)**
Inventor: **Haque, Yusuf**
**2052 Laddie Way**
**San Jose California 95121 (US)**
Inventor: **Gregorian, Roubik**
**3382 Shoreside Court**
**Santa Clara California 95050 (US)**

(74) Representative: **Jones, Ian et al**
**POLLAK MERCER & TENCH High Holborn House**
**52-54 High Holborn**
**London WC1V 6RY (GB)**

Courier Press, Leamington Spa, England.

## Description

This invention relates to a gain stage utilizing an operational amplifier and a switched capacitor resistor equivalent circuit.

The prior art is described below with reference to the following figures of the accompanying drawings:

Figure 1 schematically shows a prior art operational amplifier gain stage using switched capacitor resistor equivalents;

Figure 2 is a graphical representation of two clock signals used to control the circuit of Figure 1; and

Figure 3 shows another circuit which includes means to eliminate the effects of the operational amplifier offset voltage from the output voltage.

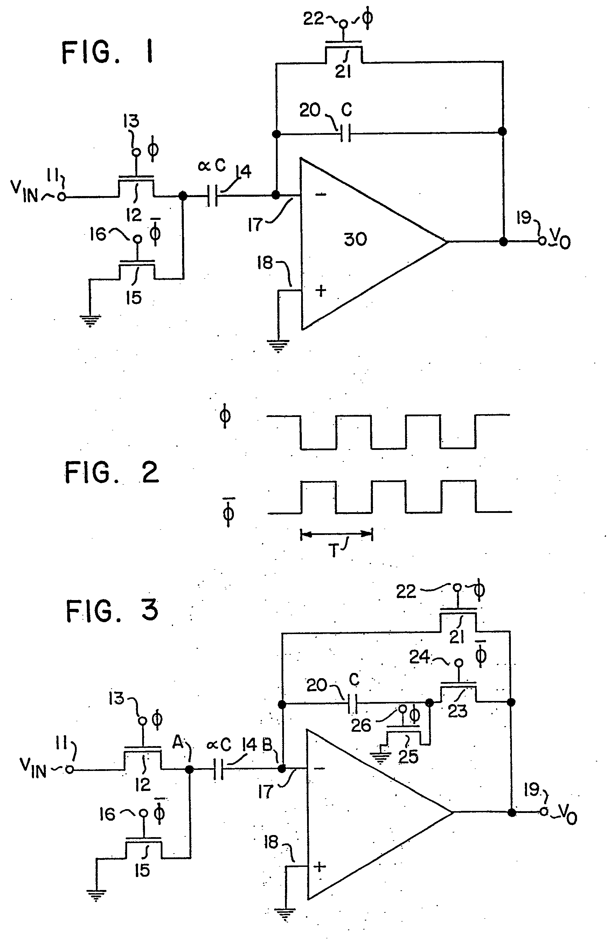

The prior art gain stage of Figure 1 utilizes an operational amplifier 30 and a switched capacitor resistor equivalent circuit. Switched capacitor resistor equivalent circuits are described, for example, in "Analog Sample Data Filters", IEEE Journal of Solid-State Circuits, August 1972, p. 302. The use of such equivalent circuits is particularly desirable in metal oxide silicon (MOS) integrated circuits, in that resistance values and thus, the ratio of resistors, which determines the gain of an operational amplifier stage, are not highly controllable in MOS integrated circuits. However, capacitance ratios are highly controllable in MOS integrated circuits, due to the fact that capacitor areas are controllable, and dielectric thicknesses are relatively uniform across the surface of the semiconductor die. Thus, capacitance ratios, and therefore the gain of operational amplifier circuits utilizing switched capacitor resistor equivalent circuits, are highly controllable in MOS integrated circuits.

The operational amplifier 30 of Figure 1 has its non-inverting input 18 connected to ground. The switched capacitor resistor equivalent circuit comprises MOS switches 12 and 15, and a capacitor 14, having capacitance value C. This switched capacitor resistor equivalent circuit is connected between an input terminal 11 and the inverting input lead 17 of the operational amplifier 30. The MOS switch 15 is connected between the capacitor 14 and ground, as shown. A capacitor 20, having capacitance C, is connected between the inverting input lead 17 and the operational amplifier output 19. MOS switch 21 is connected in parallel with capacitor 20, MOS switches 12 and 21 are controlled by a first clock signal φ, which is applied to gate terminal 13 of switch 12 and to gate terminal 22 of switch 21. MOS switch 15 is controlled by a second clock signal $\overline{φ}$, which is the inverse of φ. The relationship between signals φ and $\overline{φ}$ is shown in Figure 2.

During the operation of the prior art gain stage of Figure 1, the circuit is first initialized by discharging the capacitor 20. This is accomplished during the positive half cycle of signal φ, which causes switch 21 to close, thereby shorting out the capacitor 20. At this time, operational amplifier output 19 is connected to inverting input lead 17 through switch 21. Thus, the inherent offset voltage for operational amplifier 30, $V_{off}$, is present at both output terminal 19 and inverting input lead 17. At the same time, with φ high, switch 12 is closed, thereby charging capacitor 14 to a voltage equal to $V_{in}-V_{off}$.

When φ goes low, and $\overline{φ}$ goes high, switches 12 and 21 open and switch 15 closes. This connects one side of capacitor 14 to ground through switch 15, causing $-(V_{in}-V_{off})$ to be applied to the inverting input lead 17 of operational amplifier 30. The charge conservation equation at inverting input lead 17, is shown by Equation (1).

$$\alpha C[V_{in}(NT-\frac{T}{2})-V_{off}-(-V_{off})]$$

$$+C[0-(V_{out}(NT)-V_{off})]=0 \qquad \text{Equation (1).}$$

where

$$V_{in}(NT-\frac{T}{2})$$

equals the input voltage at time

$$NT-\frac{T}{2},$$

$V_{out}(NT)$ equals the output voltage at time NT, and N is a positive integer.

Manipulating Equation (1) to obtain an expression for $V_{out}$ leads to Equation (2).

$$V_{out}(NT)=\alpha V_{in}(NT-\frac{T}{2})+V_{off} \qquad \text{Equation (2).}$$

As can be seen from Equation (2), the inherent voltage offset, $V_{off}$, appears in the output voltage $V_{out}$. In this connection reference may be made to the Wescon Conference Record, volume 24, 16—18 September 1980, pages 26/1, 1 to 14. Elimination of the effect of $V_{off}$ in the output voltage is shown in the present Figure 3, which is identical to Figure 1, except for the addition of switches 23 and 25. During the initialization period, when signal φ is high, switches 12, 21 and 25 are closed and switches 15 and 23 are open. One plate of capacitor 20 is connected to inverting input lead 17 and output lead 19 (throughput switch 21), and the second plate of capacitor 20 is connected to ground through switch 25. Thus, rather than completely discharging capacitor 20 during the initialization period, capacitor 20 is charged to $V_{off}$. During the next half clock cycle when signal φ goes low and $\overline{φ}$ goes high, switches 12, 21 and 25 are open, and switches 15 and 23 are closed. Capacitor 20 is thus connected between inverting input lead 17 and output 19.

This results in the elimination of the offset voltage component of the output voltage, as shown in Equations (3) and (4).

$$\alpha C[V_{in}(NT-\frac{T}{2})-V_{off}-(-V_{off})]$$

$$+[C(-V_{off})-(V_{out}(NT)-V_{off})]=0 \qquad \text{Equation (3)}$$

$$V_{out}(NT)=\alpha V_{in}(NT-\frac{T}{2}) \qquad \text{Equation (4)}$$

The output voltage can be inverted if gate terminal 13 of switch 12 is connected to $\overline{\phi}$ rather than $\phi$, and gate terminal 16 of switch 15 is connected to $\phi$ rather than $\overline{\phi}$. In a similar manner, switch 15 may be connected to a second input voltage rather than ground, thus providing an output voltage proportional to the difference between the first and second input voltages.

In the absence of ideal switches, an error $E_s$ is introduced reflecting capacitive clock coupling between the gate and drain, and the gate and source, of each MOS switch. This error $E_s$ also includes charge injection which occurs when the MOS switch turns off. The mechanism of this spurious voltage $E_s$ is described in detail in United States Patent Application Serial Number 06/185,356, filed September 8, 1980. Thus, the actual output voltage is shown in Equation (5).

$$V_{out}(NT)=\alpha V_{in}(NT-\frac{T}{2})+E_s \qquad \text{Equation (5)}$$

Prior art circuits have been developed which eliminate the inherent offset voltage, $V_{off}$, from the output voltage of an operational amplifier switched capacitor resistor equivalent gain stage. (See US—A—4365204 and GB—A—2 075 781). However, prior art circuits have not been able to eliminate the effect of the error term, $E_s$, caused by parasitic capacitance of MOSFET switches, and charge injection.

The present invention accordingly provides a gain stage having an input terminal and an output terminal, the gain stage comprising:

an operational amplifier (30) having an inverting input terminal, a non-inverting input terminal connected to a voltage reference, and an output terminal;

a switched-capacitor resistor equivalent circuit responsive to a first control signal having a first ($\phi_D$) and a second ($\overline{\phi_D}$) phase, the switched-capacitor resistor equivalent circuit being connected between the input terminal of the gain stage and said inverting input terminal of the operational amplifier;

a capacitor having a first and a second plate, the first plate being connected to the inverting input terminal;

a first switch means responsive to a second control signal ($\phi$) and connected between the inverting input terminal and the amplifier output terminal, the first switch means being closed during an initialization period;

a second switch means responsive to the first control signal and connected between the second plate of the capacitor and the amplifier output terminal, the second switch means being open during the initialization period; and

a third switch means responsive to the first control signal and connected between the second plate of the capacitor and the voltage reference, the third switch means being closed during the initialization period;

characterised in that the first control signal is identical to the second control signal and delayed from the second control signal to provide two non-overlapping control signals whereby the first switch means opens after the initialization period before the second and third switch means change state thereby providing an output voltage on the amplifier output terminal free from error components caused by spurious voltages generated by the operation of the first switch means, the second switch means and the switched-capacitor resistor equivalent circuit.

The switched-capacitor resistor equivalent circuit of the gain stage of the invention can comprise for example a second capacitor having a first plate connected to the inverting input terminal of the operational amplifier, and having a second plate;

a fourth switch means responsive to the first control signal and connected between the input terminal of the gain stage and the second plate of the second capacitor; and

a fifth switch means responsive to the first control signal and connected between the second plate of the second capacitor and the voltage reference, the fourth switch means being open when the fifth switch means is closed and closed when the fifth switch means is open.

The invention also provides a method of eliminating the effect on the output voltage of the inherent offset voltage of an operational amplifier and minimizing the effect of spurious voltages generated by the switching of metal oxide silicon field effect transistors in a switched capacitor gain stage, the method comprising the steps of:

(a) connecting the non-inverting input of the operational amplifier to a reference voltage;

(b) connecting the output terminal of the operational amplifier to the inverting input terminal of the operational amplifier, thereby stabilizing the operational amplifier by causing the output terminal and the inverting input terminal of the operational amplifier to be at voltage equal to the inherent offset voltage of the operational amplifier;

(c) disconnecting the output terminal of the operational amplifier from the inverting input terminal of the operational amplifier;

(d) connecting a first plate of a first capacitor to a first input voltage, the second plate of the first capacitor being connected to the inverting input terminal of the operational amplifier, thereby charging the first capacitor to a voltage equal to the first input voltage minus the sum of the reference voltage plus the inherent offset voltage;

(e) connecting the reference voltage to a first plate of a second capacitor, the second plate of the second capacitor being connected to the inverting input terminal of the operational amplifier, thereby charging the second capacitor to a voltage equal to the reference voltage minus the inherent offset voltage;

(f) disconnecting the first plate of the first capacitor from the first input voltage;

(g) disconnecting the first plate of the second capacitor from the reference voltage;

(h) connecting the first plate of the first capacitor to a second input voltage; and

(i) connecting the first plate of the second capacitor to the output terminal of the operational amplifier;

characterised by the step (j), after completing steps (h) and (i), of disconnecting the inverting input terminal of the operational amplifier from the output terminal of the operational amplifier.

The output voltage can be defined by the following equation:

$$V_{out} = \alpha[V_{in1} - V_{in2}],$$

where

   $\alpha$ = the voltage gain of the gain stage, the voltage gain being equal to the ratio of the capacitance of the first capacitor to the capacitance of the second capacitor;

$V_{out}$ = the output voltage appearing in the output terminal;

$V_{in1}$ = the first input voltage; and

$V_{in2}$ = the second input voltage.

The invention is further described below, by way of example, with reference to the following figures of the accompanying drawings:

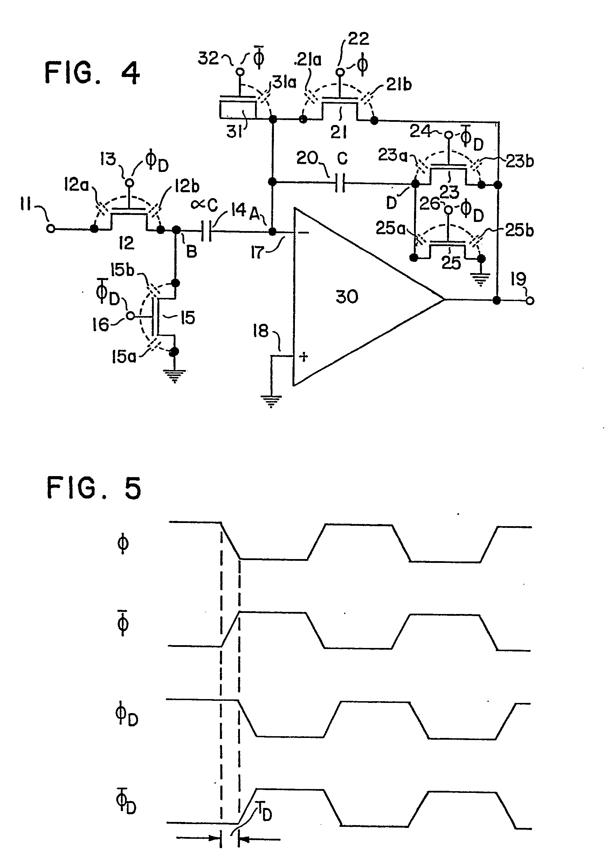

Figure 4 is a schematic circuit diagram of a gain stage embodying this invention; and

Figure 5 is a graphical representation of two clock signals required to operate the circuit of Figure 4.

Components of the circuit schematically shown in Figure 4 which operate in the same fashion as those shown in the prior art circuit of Figure 3 are similarly numbered. Parasitic capacitors, such as capacitor 15a and 15b associated with MOS switch 15, are shown with dashed lines in Figure 4. In contrast with prior art circuits, the clock signals used to operate the circuit of Figure 4, as shown in Figure 5, are not simply inverted, but rather also delayed. $\phi_D$ is a clock signal of the same period and duty cycle as clock signal $\phi$; however, signal $\phi_D$ is delayed by a time $T_D$, such that the rising and falling edges of signal $\phi_D$. MOS switch 21 must be completely turned off prior to the switching of MOS switches 12, 15, 23 and 25. In this way, the voltage on output terminal 19 of operational amplifier 30 is dependent only upon the initial input voltage applied to input terminal 11; spurious voltages caused by the operation of switches 12, 15, 23 and 25 have no effect on the output voltage. In practice, $T_D$ is equal to approximately 30—150 nanoseconds, although this delay is dependent on the switching speeds of the switches used.

The operation of the circuit of this invention shown in Figure 4 is as follows. During the period when $\phi$ and $\phi_D$ are high, switches 12, 21, and 25 are closed. With switch 21 closed, the output terminal 19 of operational amplifier 30 is connected to inverting input lead 17, thus causing $V_{off}$, the inherent offset voltage of operational amplifier 30, to be present both on output terminal 19 and inverting input lead 17. Capacitor 20 has a capacitance value C; capacitor 14 has a capacitance value $\alpha$C. With one plate of capacitor 20 connected to inverting input lead 17, and the other plate of capacitor 20 connected to ground through switch 25, capacitor 20 is charged to $V_{off}$. $\phi$ then goes low, causing switch 21 to open. A small error voltage, $E_S$ is introduced when switch 21 opens, as previously described. However, the effect of this spurious error voltage may be minimized by proper design of switch 21, and the use of dummy switch 31, whose gate terminal 32 is driven by signal $\overline{\phi}$, as shown. The use of dummy switches is disclosed in U.S. Patent No. 3,983,414. The methods of minimizing parasitic error voltage due to MOS switch operation, including the use of dummy switches, is also described in US—A—4365204, mentioned previously.

Signal $\phi_D$ then goes low, and $\overline{\phi}_D$ goes high. This causes switches 12 and 25 to open, and switches 15 and 23 to close. Following the closure of switches 15 and 23, any spurious voltage generated by the operation of switches 12 or 15 will have no effect on the gain stage of Figure 4, as node B is connected to ground (or any other suitable low impedance voltage reference) thus eliminating any spurious error voltage induced on node B by the operation of MOSFET switches 12 and 15. In a similar manner, the operation of MOSFET switches 23 and 25 will have no adverse effect on the output voltage available at terminal 19, in that node D is connected to output terminal 19 of operational amplifier 30, which is also a low impedance point.

Although there has been disclosed an embodiment of this invention wherein various switches operate simultaneously, (i.e., switches 12, 15, 23 and 25), the invention may be embodied in a circuit where various switches are not operated simultaneously. For example, switch 15 may close after switch 12 opens; switch 23 may close after switch 25 opens. Of importance, however, is the fact that switch 21 must open after each initialization period before switches 12, 15, 23 and 25 change state. By utilizing this time delay, spurious voltages generated by the operation of switches 12, 15, 23 and 25 are prevented from affecting the output voltage on output terminal 19.

Thus, by the use of the timing scheme of this invention, an operational amplifier gain stage utilizing a switched capacitor resistor equivalent circuit may be formed in such a manner as to eliminate the spurious error voltages generated through the use of MOSFET switches. Circuit complexity and area are reduced by the elimination of all but a single dummy switch used in the prior art to minimize spurious error voltages generated when utilizing MOSFET switches in switched capacitor circuits.

## Claims

1. A gain stage having an input terminal (11) and an output terminal (19), the gain stage comprising:

an operational amplifier (30) having an inverting input terminal (17), a non-inverting input terminal (18) connected to a voltage reference, and an output terminal;

a switched-capacitor resistor equivalent circuit (12, 14, 15) responsive to a first control signal having a first ($\phi_D$) and a second $(\overline{\phi_D})$ phase, the switched-capacitor resistor equivalent circuit being connected between the input terminal (11) of the gain stage and said inverting input terminal (17) of the operational amplifier;

a capacitor (20) having a first and a second plate, the first plate being connected to the inverting input terminal (17);

a first switch means (21) responsive to a second control signal ($\phi$) and connected between the inverting input terminal (17) and the amplifier output terminal, the first switch means being closed during an initialization period;

a second switch means (23) responsive to the first control signal and connected between the second plate of the capacitor (20) and the amplifier output terminal, the second switch means being open during the initialization period; and

a third switch means (25) responsive to the first control signal and connected between the second plate of the capacitor (20) and the voltage reference, the third switch means being closed during the initialization period;

characterised in that the first control signal is identical to the second control signal and delayed ($T_D$) from the second control signal to provide two non-overlapping control signals whereby the first switch means (21) opens after the initialization period before the second (23) and third (25) switch means change state thereby providing an output voltage on the amplifier output terminal free from error components caused by spurious voltages generated by the operation of the first switch means (21), the second switch means (23) and the switched-capacitor resistor equivalent circuit (12, 14, 15).

2. A gain stage as claimed in claim 1 wherein the delay between the second control signal and the first control signal is in the range of approximately 30—150 nanoseconds.

3. A gain stage as claimed in claim 1 or 2 wherein the switch means are metal oxide silicon field effect transistors.

4. A gain stage as claimed in claim 3 comprising a dummy switch means (31) responsive to the second control signal, the dummy switch means being connected to the inverting input terminal (17) of the operational amplifier (30).

5. A gain stage as claimed in claim 1, 2, 3 or 4 wherein the switched capacitor resistor equivalent circuit comprises:

a second capacitor (14) having a first plate connected to the inverting input terminal (17) of the operational amplifier (30), and having a second plate;

a fourth switch means (12) responsive to the first control signal and connected between the input terminal (11) of the gain stage and the second plate of the second capacitor (14); and

a fifth switch means (15) responsive to the first control signal and connected between the second plate of the second capacitor (14) and the voltage reference, the fourth switch means (12) being open when the fifth switch means (15) is closed and closed when the fifth switch means is open.

6. A gain stage as claimed in any preceding claim wherein the voltage reference is ground.

7. A method of eliminating the effect on the output voltage of the inherent offset voltage of an operational amplifier and minimizing the effect of spurious voltages generated by the switching of metal oxide silicon field effect transistors in a switched capacitor gain stage, the method comprising the steps of:

(a) connecting the non-inverting input (18) of the operational amplifier (30) to a reference voltage;

(b) connecting the output terminal of the operational amplifier (30) to the inverting input terminal (17) of the operational amplifier, thereby stabilizing the operational amplifier by causing the output terminal and the inverting input terminal of the operational amplifier to be at voltage equal to the inherent offset voltage of the operational amplifier;

(c) disconnecting the output terminal of the operational amplifier (30) from the inverting input terminal (17) of the operational amplifier;

(d) connecting a first plate of a first capacitor (14) to a first input voltage, the second plate of the first capacitor (14) being connected to the inverting input terminal (17) of the operational amplifier, thereby charging the first capacitor (14) to a voltage equal to the first input voltage minus the sum of the reference voltage plus the inherent offset voltage;

(e) connecting the reference voltage to a first plate of a second capacitor (20), the second plate of the second capacitor (20) being connected to the inverting input terminal (17) of the operational amplifier, thereby charging the second capacitor (20) to a voltage equal to the reference voltage minus the inherent offset voltage;

(f) disconnecting the first plate of the first capacitor (14) from the first input voltage;

(g) disconnecting the first plate of the second capacitor (20) from the reference voltage;

(h) connecting the first plate of the first capacitor (14) to a second input voltage; and

(i) connecting the first plate of the second capacitor (20) to the output terminal of the operational amplifier;

characterised by the step (j), after completing steps (h) and (i), of disconnecting the inverting input terminal (17) of the operational amplifier from the output terminal of the operational amplifier.

8. A method as claimed in claim 7 wherein step (j) occurs approximately 30—150 nanoseconds after the occurrence of steps (g) and (h).

9. A method as claimed in claim 7 or 8 wherein the output voltage is defined by the following equation:

$$V_{out} = a[V_{in1} - V_{in2}],$$

where

a = the voltage gain of the gain stage, the voltage gain being equal to the ratio of the capacitance of the first capacitor to the capacitance of the second capacitor;

$V_{out}$ = the output voltage appearing in the output terminal;

$V_{in1}$ = the first input voltage; and

$V_{in2}$ = the second input voltage.

10. A method as claimed in claim 7, 8 or 9 wherein the second input voltage is the reference voltage.

**Patentansprüche**

1. Verstärkungsstufe mit einem Eingangsanschluß (11) und einem Ausgangsanschluß (19), wobei die Verstärkungsstufe aufweist:

einen Operationsverstärker (30) mit einem invertierenden Eingangsanschluß (17), einem nicht invertierenden Eingangsanschluß (18), der mit einer Referenzspannungsquelle verbunden ist und einem Ausgangsanschluß.

eine geschaltete Kondensator-Widerstands-Äquivalenzschaltung (12, 14, 15), die auf ein erstes Steuersignal anspricht, welches eine erste ($\phi_D$) und eine zweite ($\phi_D$) Phase aufweist, wobei die geschaltete Kondensator-Widerstands-Äquivalenzschaltung zwischen dem Eingangsanschluß (11) der Verstärkungsstufe und dem invertierenden Eingangsanschluß (17) des Operationsverstärkers angeordnet ist,

ein Kondensator (20) mit einer ersten und zweiten Platte, wobei die erste Platte mit dem intervierenden Eingangsanschluß (17) verbunden ist,

eine erste Schalteinrichtung (21), die auf ein zweites Steuersignal ($\phi$) anspricht und zwischen dem invertierenden Eingangsanschluß (17) und dem Verstärkerausgangsanschluß angeordnet ist, wobei die erste Schalteinrichtung während einer Initialisierungs- bzw. Startperiode geschlossen ist;

eine zweite Schalteinrichtung (23), die auf das erste Steuersignal anspricht und zwischen der zweiten Platte des Kondensators (20) und dem Verstärkerausgangsanschluß vorgesehen ist, wobei die zweite Schalteinrichtung während der Initialisierungs- bzw Startperiode geöffnet ist, und ein dritte Schalteinrichtung (25), die auf das erste Steuersignal anspricht und zwischen der zweiten Platte des Kondensators (20) und der Referenzspannungsquelle vorgesehen ist, wobei die dritte Schalteinrichtung während der Initialisierungs- bzw. Startperiode geschlossen ist,

dadurch gekennzeichnet, daß das erste Steuersignal identisch dem zweiten Steuersignal ist und verzögert ($T_0$) gegenüber dem zweiten Steuersignal, um zwei nicht überlappende Steuersignale zu schaffen, wodurch der erste Schalter (21) nach der Initialisierungsperiode öffnet bevor der zweite (23) und der dritte (25) Schalter den Zustand ändern, um dadurch eine Ausgangsspannung am Verstärkerausgangsanschluß zu liefern frei von Fehlerkomponenten, welche durch ungewollte Spannungen verursacht sind, die durch die Betätigung der Schalteinrichtung (21), die zweite Schalteinrichtung (23) und die geschaltete Kondensator-Widerstands-Äquivalenzschaltung (12, 14, 15) verursacht werden.

2. Verstärkerstufe nach Anspruch 1, dadurch gekennzeichnet, daß die Verzögerung zwischen dem zweiten Steuersignal und dem ersten Steuersignal in einem Bereich von ungefähr 30 bis 150 Nanosekunden liegt.

3. Verstärkerstufe nach Anspruch 1 oder 2, dadurch gekennzeichnet, daß die Schalteinrichtung aus Metalloxid-Silizium-Feldeffekttransistoren besteht.

4. Verstärkerstufe nach Anspruch 3, dadurch gekennzeichnet, daß eine Schein- oder Blindschalteinrichtung (31) vorgesehen ist, welche auf das zweite Steuersignal hin anspricht, wobei die Scheinschalteinrichtung mit dem invertierenden Eingangsanschluß (17) des Operationsverstärkers (30) verbunden ist.

5. Verstärkerstufe nach einem der Ansprüche 1, 2, 3 oder 4, dadurch gekennzeichnet, daß die geschaltete Kondensator-Widerstands-Äquivalenzschaltung aufweist:

einen zweiten Kondensator (14) mit einer ersten Platte, die mit dem invertierenden Eingangsanschluß (17) des Operationsverstärkers (30) verbunden ist und eine zweite Platte enthält,

eine vierte Schalteinrichtung (12), die auf das erste Steuersignal anspricht und zwischen dem Eingangsanschluß (11) der Verstärkerstufe und der zweiten Platte des zweiten Kondensators (14) vorgesehen ist, und

eine fünfte Schalteinrichtung (15), die auf das erste Steuersignal anspricht und zwischen der zweiten Platte des zweiten Kondensators (14) und der Referenzspannungsquelle vorgesehen ist, wobei die vierte Schalteinrichtung (12) geöffnet ist, wenn die fünfte Schalteinrichtung (15) geschlossen ist und geschlossen ist, wenn die fünfte Schalteinrichtung geöffnet ist.

6. Verstärkerstufe nach einem der vorher-

11      **0 060 026**      12

gehenden Ansprüche, dadurch gekennzeichnet, daß die Referenzspannung Erdpotential aufweist.

7. Verfahren zur Beseitigung der Wirkung der bei einer Ausgangsspannung vorhandenen inherenten Verschiebespannung eines Operationsverstärkers und zur Verringerung der Wirkung von ungewollten Spannungen, die durch das Schalten von Metalloxid-Silizium-Feldeffekttransistoren in einer geschalteten Kondensator-Verstärkerstufe erzeugt werden, wobei das Verfahren die folgenden Schritte aufweist:

(a) Verbinden des nicht invertierenden Einganges (18) des Operationsverstärkers (30) mit einer Referenzspannung,

(b) Verbinden des Ausgangsanschlusses des Operationsverstärkers (30) mit dem invertierenden Eingangsanschluß (17) des Operationsverstärkers, wobei der Operationsverstärker dadurch stabilisiert wird, daß der Ausgangsanschluß und der invertierende Eingangsanschluß des Operationsverstärkers auf eine Spannung gebracht wird, die gleich der inherenten Verschiebespannung des Operationsverstärkers ist,

(c) Trennen des Ausgangsanschlusses des Operationsverstärkers (30) von dem invertierenden Eingangsanschluß (17) des Operationsverstärkers,

(d) Verbindung der ersten Platte des ersten Kondensators (14) mit einer ersten Eingangsspannung, wobei die zweite Platte des ersten Kondensators (14) mit dem invertierenden Eingangsanschluß (17) des Operationsverstärkers verbunden wird, wobei der erste Kondensator (14) auf eine Spannung aufgeladen wird, die gleich der ersten Eingangsspannung minus der Summe der Referenzspannung plus der inherenten Verschiebespannung ist,

(e) Verbinden der Referenzspannung mit einer ersten Platte eines zweiten Kondensators (20), wobei die zweite Platte des zweiten Kondensators (20) mit dem invertierenden Eingangsanschluß (17) des Operationsverstärkers verbunden wird, wodurch der zweite Kondensator (20) auf eine Spannung aufgeladen wird, die gleich der Referenzspannung minus der inherenten Verschiebespannung ist,

(f) Trennen der ersten Platte des ersten Kondensators (14) von der ersten Eingangsspannung,

(g) Trennen der ersten Platte des zweiten Kondensators (20) von der Referenzspannung,

(h) Verbinden der ersten Platte des ersten Kondensators (14) mit einer zweiten Eingangsspannung, und

(i) Verbinden der ersten Platte des zweiten Kondensators (20) mit dem Ausgangsanschluß des Operationsverstärkers,

gekennzeichnet durch den Schritt (j) nach Beendigung der Schritte (h) und (i), nämlich Trennen des invertierenden Eingangsanschlusses (17) des Operationsverstärkers von dem Ausgangsanschluß des Operationsverstärkers.

8. Verfahren nach Anspruch 7, dadurch gekennzeichnet, daß der Schritt (j) ungefähr 30 bis 150 Nanosekunden dauert nach dem Auftreten der Schritte (g) und (h).

9. Verfahren nach Anspruch 7 oder 8, dadurch gekennzeichnet, daß die Ausgangsspannung definiert ist durch die folgende Gleichung:

$$V_{out} = \alpha[V_{in1} - V_{in2}],$$

in der bedeuten:

$\alpha$ = die Spannungsverstärkung der Verstärkerstufe, wobei die Spannungsverstärkung gleich dem Verhältnis der Kapazität des ersten Kondensators zur Kapazität des zweiten Kondensators ist,

$V_{out}$ = die Ausgangsspannung, die am Ausgangsanschluß auftritt,

$V_{in1}$ = die erste Eingangsspannung und

$V_{in2}$ = die zweite Eingangsspannung.

10. Verfahren nach einem der Ansprüche 7, 8 oder 9, dadurch gekennzeichnet, daß die zweite Eingangsspannung die Referenzspannung ist.

**Revendications**

1. Un étage de gain comportant une borne d'entrée (11) et une borne de sortie (19), l'étage de gain comprenant: un amplificateur opérationnel (30) avant une borne l'entrée inverseuse (17), une borne d'entrée (18) non inverseuse reliée à une tension de référence, et une borne de sortie, un circuit équivalent à condensateur commuté et à résistance (12, 14, 15) sensible à un premier signal de commande ayant une première phase ($\phi_D$) et une seconde phase ($\overline{\phi_D}$), le circuit équivalent à condensateur commuté et à résistance étant relié entre la borne d'entrée (11) de l'étage de gain et ladite borne d'entrée inverseuse (17) de l'amplificateur opérationnel; un condensateur (20) ayant une première et une seconde armatures, la première armature étant reliée à la borne d'entrée inverseuse (17), un premier dispositif commutateur (21) sensible à un second signal de commande ($\phi$) et relié entre la borne d'entrée inverseuse (17) et la borne de sortie de l'amplificateur, le premier dispositif commutateur étant fermé pendant une période d'initialisation, un second dispositif commutateur (23) sensible au premier signal de commande et connecté entre la seconde armature du condensateur (20) et la borne de sortie de l'amplificateur, le second dispositif commutateur étant ouvert pendant la période d'initialisation et un troisième dispositif commutateur (25) sensible au premier signal de commande et relié entre la seconde armature du condensateur (20) et la tension de référence, le troisième commutateur étant fermé pendant la période d'initialisation, caractérisé en ce que le premier signal de commande est identique au second signal de commande et est retardé depuis le second signal de commande pour fournir deux signaux de commande ne se recouvrant pas, grâce à quoi le premier commutateur (21) s'ouvre après la période d'initialisation avant que le second commutateur (23) et le troisième commutateur (25) changent d'état, fournissant ainsi une tension de sortie sur la borne de sortie de l'amplificateur qui est dépourvue de toute composante d'erreur provoquée par des tensions parasites engendrées par le fonctionnement des dispositifs de commutation (21), le second dispositif de commutation (23) et le circuit équivalent à condensateur commuté et à résistance (12, 14, 15).

2. Un étage de gain tel que revendiqué dans la revendication 1, dans lequel le retard entre le second signal de commande et le premier signal de commande est compris dans la plage d'approximativement 30 à 150 nanosecondes.

3. Un étage de gain tel que revendiqué dans la revendication 1 ou 2, dans lequel le dispositif commutateur est constitué par des transistors métal-oxyde-silicium à effet de champ.

4. Un étage de gain tel que revendiqué dans la revendication 3, caractérisé en ce qu'il comprend un dispositif (31) de commutateur fictif sensible au second signal de commande, le commutateur fictif étant relié à la borne d'entrée inverseuse (17) de l'amplificateur opérationnel (30).

5. Un étage de gain tel que revendiqué dans les revendications 1, 2, 3 ou 4, dans lequel le circuit équivalent à condensateur commuté et à résistance comprend: un second condensateur (14) ayant une première armature reliée à la borne d'entrée inverseuse (17) de l'amplificateur opérationnel (30), et comportant une seconde armature, un quatrième dispositif commutateur (12) sensible au premier signal de commande et relié entre la borne d'entrée (11) de l'étage de gain et la seconde armature du second condensateur (14), et un cinquième dispositif commutateur (15) sensible au premier signal de commande et relié entre la seconde armature du second condensateur (14) et la tension de référence, le quatrième dispositif commutateur (12) étant ouvert lorsque le cinquième dispositif commutateur (15) est fermé et étant fermé lorsque le cinquième dispositif commutateur est ouvert.

6. Un étage de gain tel que revendiqué dans l'une quelconque des revendications précédentes, dans lequel la tension de référence est la masse.

7. Un procédé pour éliminer l'effet sur la tension de sortie de la tension résiduelle inhérente d'un amplificateur opérationnel et pour diminuer l'effet des tensions parasites engendrées par la commutation des transistors à effet de champ métal-oxyde-silicium, dans un étage de gain à condensateur commuté, ce procédé comprenant les phases consistant:

(a) à relier la borne d'entrée non inverseuse (18) de l'amplificateur opérationnel (30) à une tension de référence;

(b) à relier la borne de sortie de l'amplificateur opérationnel (30) à la borne d'entrée inverseuse (17) de l'amplificateur opérationnel, stabilisant ainsi l'amplificateur opérationnel en astreignant la borne de sortie et la borne d'entrée inverseuse de l'amplificateur opérationnel à se trouver à une tension égale à la tension résiduelle inhérente de l'amplificateur opérationnel.

(c) à déconnecter la borne de sortie de l'amplificateur opérationnel (30) de la borne d'entrée inverseuse (17) de l'amplificateur opérationnel;

(d) à connecter la première armature d'un premier condensateur (14) à une première tension d'entrée, la seconde armature du premier condensateur (14) étant reliée à la borne d'entrée inverseuse (17) de l'amplificateur opérationnel, chargeant ainsi le premier condensateur (14) jusqu'à une tension égale à la première tension d'entrée diminuée de la somme de la tension de référence plus la tension résiduelle inhérente;

(e) à connecter la tension de référence à une première armature d'un second condensateur (20), la seconde armature du second condensateur (20) étant reliée à la borne d'entrée inverseuse (17) de l'amplificateur opérationnel, chargeant ainsi le second condensateur (20) jusqu'à une tension égale à la tension de référence diminuée de la tension résiduelle inhérente;

(f) à déconnecter la première armature du premier condensateur (14) de la première tension de sortie;

(g) à déconnecter la première armature du second condensateur (20) de la tension de référence;

(h) à connecter la première armature du premier condensateur (14) à une seconde tension d'entrée;

(i) à connecter la première armature du second condensateur (20) à la borne de sortie de l'amplificateur opérationnel; caractérisé par la phase (j) après l'achèvement des phases (h) et (i), consistant à déconnecter la borne d'entrée inverseuse (17) de l'amplificateur opérationnel (30) de la borne de sortie de l'amplificateur opérationnel.

8. Un procédé tel que revendiqué dans la revendication 7 dans lequel la phase (j) se produit approximativement de 30 à 150 nanosecondes après qu'aient été effectuées les phases (g) et (h).

9. Un procédé tel que revendiqué dans la revendication 7 ou 8, dans lequel la tension de sortie est désignée par l'équation suivante:

$$V_{sor} = \alpha[V_{ent1} - V_{ent2}]$$

dans laquelle:
- $\alpha$ = le gain de tension de l'étage de gain, le gain de tension étant égal au rapport capacitif du premier condensateur à la capacité du second condensateur;
- $V_{sor}$ = la tension de sortie apparaissant à la borne de sortie;
- $V_{ent1}$ = la première tension d'entrée;
- $V_{ent2}$ = la seconde tension d'entrée.

10. Un procédé tel que revendiqué dans les revendications 7, 8 ou 9 dans lequel la seconde tension d'entrée est la tension de référence.

FIG. 1

FIG. 2

FIG. 3

**FIG. 4**

**FIG. 5**